Europäisches Patentamt
European Patent Office
Office européen des brevets

(19)

(11) Publication number: 0 065 686 A2

(12) EUROPEAN PATENT APPLICATION

(21) Application number: 82104013.6

(22) Date of filing: 08.05.82

(51) Int. Cl.³: H 01 L 23/36
H 01 L 23/14

(30) Priority: 21.05.81 US 265868

(43) Date of publication of application:
01.12.82 Bulletin 82/48

(84) Designated Contracting States:
DE FR GB SE

(71) Applicant: GENERAL ELECTRIC COMPANY
1 River Road
Schenectady New York 12305(US)

(72) Inventor: Yerman, Alexander John
1015 Cherokee Road
Scotia New York 12302(US)

(72) Inventor: Loughran, James Anthony
33 Harmon Road
Scotia New York 12302(US)

(74) Representative: Voigt, Reinhard, Dipl.-Ing. European Patent Attorney et al,
Kaiserstrasse 41
D-6000 Frankfurt (Main) 1(DE)

# (54) Power device module.

(57) An improved power device module comprises a power device such as a power transistor or power resistor attached to a dielectric substrate such as beryllia ceramic, which, in turn, is attached to an aluminum heat exchanger with a structural adhesive.

FIG. 1

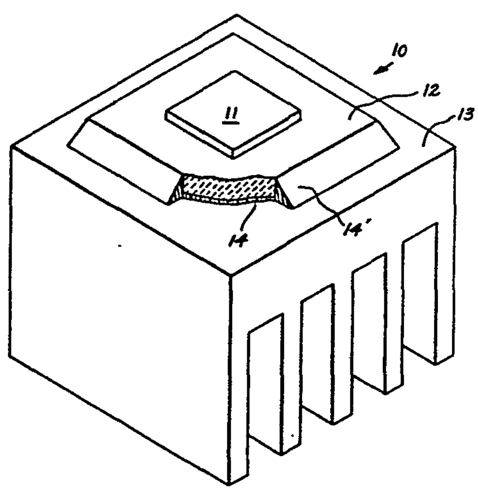


EP 0 065 686 A2

# AN IMPROVED POWER DEVICE MODULE

## Background of the Invention

The present invention relates to an improved power device module, and more particularly to such a module incorporating a power device and an aluminum heat exchanger.

A "power device module" as used herein comprises a power device together with heat dissipation components, which are assembled as a unit. As used herein, "power devices" comprise "active" semiconductor devices and "passive" devices such as resistors having a power dissipation density in excess of about 10 watts per square centimeter.

It is necessary to extract heat from power devices in order to maintain acceptably low device temperatures. A typical prior art power device module includes means for extracting heat from a power device which means comprises an aluminum heat exchanger and a metallic heat spreader plate, typically of copper, mounted on an upper surface of the aluminum heat exchanger. Such heat spreader plate is mechanically attached to the aluminum heat exchanger as, for example, with bolts or rivets. Also included in the means for extracting heat is a dielectric substrate, typically of alumina, which is soldered to an upper surface of the heat spreader plate and which has the power device mounted on an upper surface thereof.

The purposes for interposing the dielectric substrate and the metallic heat spreader plate between the power device and the aluminum heat exchanger are as follows. The dielectric substrate serves to provide electrical dielectric isolation between the power device and the aluminum heat exchanger. The heat spreader plate serves to spread the heat from the power device to a relatively larger area of the aluminum heat exchanger whereby the thermal conductivity between the power device and the aluminum heat exchanger is increased and, additionally, localized regions of low thermal conductivity in the interface between the heat spreader plate and the aluminum heat exchanger are not able to seriously impair the heat transfer through this interface.

The foregoing typical prior art power device module has several drawbacks. First, the metallic heat spreader plate is subject to warpage because it tends to thermally contract at a faster rate than the dielectric substrate to which it is soldered as the module assembly cools after the soldering is completed. As a result of this fact, the bottom surface of a metallic heat spreader plate becomes warped in a concave fashion. Such warpage seriously degrades the thermal conductivity between the metallic heat spreader plate and the aluminum heat exchanger on which the metallic heat spreader plate is mounted. Second, the aluminum heat exchanger, which is typically formed by extrusion, usually has a non-flat mounting surface for the heat spreader plate, and also usually exhibits a rough or textured mounting surface. It is not uncommon for such mounting surface of the aluminum heat exchanger to have a deviation from flatness of four mils per inch. To remedy such a non-flat mounting surface requires an expensive machining operation. A rough or textured mounting surface is usually accommodated by the provision of heat transfer grease in the interface region between the heat spreader plate and the aluminum heat exchanger in order to displace air from this interface. The long-term reliability of such provision of heat transfer grease is difficult to predict accurately due to its tendency to creep or migrate. Third, the soldered joint between the dielectric substrate and the metallic heat spreader plate is susceptible to the presence of voids therein and also to thermal cycling fatigue. Such voids in the solder are due to trapped gas originating in the solder, from entrained flux, or from the ambient gas or fluid present when the soldering takes place. Such voids degrade heat transfer through the solder joint and can cause local hot spots. Thermal cycling fatigue of the solder raises a serious risk of structurally and thermally degrading the solder joint especially where wide ambient temperature excursions of the solder are encountered.

Objects of the Invention

Accordingly, it is an object of the present invention to provide an improved power device module which eliminates the use of a metallic heat spreader plate and the warpage problem associated therewith.

It is a further object of the present invention to provide an improved power device module which is tolerant of more surface roughness and lack of flatness of the mounting surface of an extruded aluminum heat exchanger than is the prior art power device module described above.

It is a still further object of the present invention to provide an improved power device module not requiring a solder joint between a dielectric substrate and a metallic heat spreader plate and also not requiring solderable metal layers on the confronting surfaces of such dielectric substrate and such metallic heat spreader plate, thereby avoiding the problems of a solder joint described above.

It is a yet further object of the present invention to provide an improved power device module having a lower assembly cost and being more easily repairable than the prior art power device module discussed above.

Further objects and advantages of the present invention will become apparent from a reading of the remainder of this specification in conjunction with the drawing figures.

## Summary of the Invention

In carrying out the objects of the present invention in one form, there is provided an improved power device module. The module comprises a power device which is attached to the upper surface of a dielectric substrate, and an aluminum heat exchanger. An upper surface of the aluminum heat exchanger is attached to a lower surface of the dielectric substrate by means of a structural adhesive. The structural adhesive is disposed between substantially the entire area of the dielectric substrate lower surface and the aluminum heat exchanger upper surface. The dielectric substrate performs multiple functions: it performs a heat spreading function for the power device, and does so paricularly well where it comprises the preferred material, beryllia ceramic; it serves as dielectric isolation means between the power device and the aluminum heat exchanger; and it serves as a strain buffer between the power device and the aluminum heat exchanger.

The structural adhesive can be applied with relative ease, usually at room temperature, and is better able to accommodate more surface roughness and lack of flatness in the upper mounting surface of the aluminum heat exchanger than the prior art power device module described above.

## Brief Description of the Drawing Figures

FIGURE 1 is a perspective view of a power device module in accordance with the present invention;

FIGURE 2 is a graph illustrating the thermal resistance from the "junction" of a power semiconductor device to an aluminum heat exchanger versus the area of a dielectric substrate for four different implementations of the dielectric substrate;

FIGURE 3 is a graph of thermal resistance from the junction of a power semiconductor device to an aluminum heat exchanger versus the area of a dielectric substrate for five different thicknesses of a particular structural adhesive between the dielectric substrate and the aluminum heat exchanger.

## Detailed Description of the Invention

There is shown in Fig. 1 a power device module 10 comprising a power device 11, a dielectric substrate 12, an aluminum heat exchanger 13, and a structural adhesive 14. The power device 10, illustrated diagrammatically, typically comprises a discrete power semiconductor device such as a transistor, a power Darlington transistor, a diode, a thyristor, a power MOSFET, or a photovoltaic cell, an integrated circuit, or a passive power device such as a power resistor.

The present invention can be practiced with a plurality of the foregoing devices in any combination; however,only one power device 11 is described herein to facilitate understanding of the present invention. The device 10 is suitably attached to the upper surface of the dielectric substrate 12 by conventional means, such as by soldering or by eutectic bonding.

The dielectric substrate 12 serves three different purposes. First, the dielectric substrate 12 serves as a heat spreader for the power device 11. The substrate 12 has a main or horizontal area which is large relative to the main or horizontal area of the device 11. Accordingly, the substrate 12 is able to transfer heat from the device 11 to the aluminum heat exchanger 13(via the structural adhesive 14) through a thermal path comprising substantially the entire volume of the substrate 12. The provision of such a broad thermal path significantly enhances the thermal conductivity of the substrate 12 in contrast with the situation that would exist if a narrow thermal path were provided between the device 11 and the heat exchanger 13. Such a narrow thermal path would exist if the main area of the dielectric substrate 12 were not larger than the main area of device 11. Second, the dielectric substrate 12 serves to provide electrical dielectric isolation between the power device 11 and the aluminum heat exchanger 13. As a result of this fact, the substrate 12 can accommodate several thousands of volts difference between the device 11 and the heat exchanger 13, at least where the substrate 12 has the preferred dimensions as discussed below. Additionally, with the main area of the device 11 smaller than the main area of the substrate 12, a large "electrical creepage" distance between the device 11 and the heat exchanger 13 is provided. Third, the dielectric substrate 12 serves as a "strain buffer" between the power device 11 and the aluminum heat exchanger 13. The necessity of a strain buffer between the foregoing parts follows from the different thermal expansion coefficients of the device 11 and heat exchanger 13, which differ from each other by a factor of about 8.5 where the device 11 comprises silicon and the heat exchanger 13 comprises aluminum. The thermal expansion coefficient of the dielectric substrate 12 is between the thermal expansion coefficients of the device 11 and the heat exchanger 13, whereby, for a thickness of the substrate 12 in the preferred range given below, it is able to buffer or cushion the thermal expansion strain between the device 11 and the heat exchanger 13.

The dielectric substrate 12 preferably comprises beryllia ceramic having a thermal conductivity of about 2.2 watts per centimeter per degree Celcius. The present inventors have discovered that the dielectric substrate 12, where it comprises beryllia ceramic having the foregoing thermal conductivity, is especially able to transfer heat very efficiently from the power device 11 to the aluminum heat exchanger 13 despite the relatively low thermal conductivity of the intermediate structural adhesive 14 (discussed in detail below). The present invention, however, can be practiced with the dielectric substrate 12 comprising alumina ceramic. Alumina ceramic has an inferior thermal conductivity property than beryllia ceramic as borne out by the data of Fig.2 (discussed below). Alumina ceramic, however, has a more desirable strain buffer capacity than beryllia ceramic. Materials other than beryllia or alumina ceramic can be used for the dielectric substrate 12, however. provided that they are able to fulfill the three purposes discussed in the preceding paragraph.

The selection of suitable dimensions for the dielectric substrate 12 will be guided by a study of the graph of Fig. 2, once a desired thermal resistance from the power device 11 to the heat exchanger 13 has been determined. This graph illustrates the thermal resistance between the "junction" of the power device 11 comprising a power semiconductor device and the upper surface of the aluminum heat exchanger 13 versus the area of the dielectric substrate 12 for four different implementations thereof. The effective area of the dielectric substrate 12 is the main or horizontal area thereof. The graph of Fig. 2 is subject to the following two fixed parameters: the main or horizontal area of the power device 11 is 0.63 square centimeter; and the structural adhesive 14 comprises an 8 mil thick layer of Thermal Bond X epoxy resin sold by Thermal Associates of Stoneham, Massachusetts. Thermal Bond X epoxy resin has a thermally conductive filler of powdered aluminum. (Further details of the structural adhesive 14 are discussed below). For each of the four curves representing different implementations of the dielectric substrate 12 as shown in Fig. 2, it can be appreciated that the main or horizontal area of the dielectric substrate 12 should be large relative to the main or horizontal area of the power device 11.

Preferably, the main area of the dielectric substrate 12 exceeds about 3 square centimeters for a power device 11 having a main area of 0.63 square centimeters, whereby the thermal resistances of each of the different implementations of the substrate 12 are represented by the substantially flat portions of the respective curves therefor in Fig. 2. For a power device 11 having a main area in excess of 0.63 square centimeters, the relative main area of a dielectric substrate 12, where it comprises beryllia or alumina ceramic, should be greater than about 5 times as large as the main area of the device 11. A preferred range of thickness of the dielectric substrate 12 for fulfilling the three purposes mentioned above is between about 20 and 100 mils. The selection of a suitable thickness for the dielectric substrate 12 is interdependent with the selection of a suitable thickness of the structural adhesive 14, discussed in detail below. The thicker the structured adhesive 14 is, the thicker the dielectric substrate 12 should be in order to achieve a reasonable thermal conductivity across the combination of these two materials.

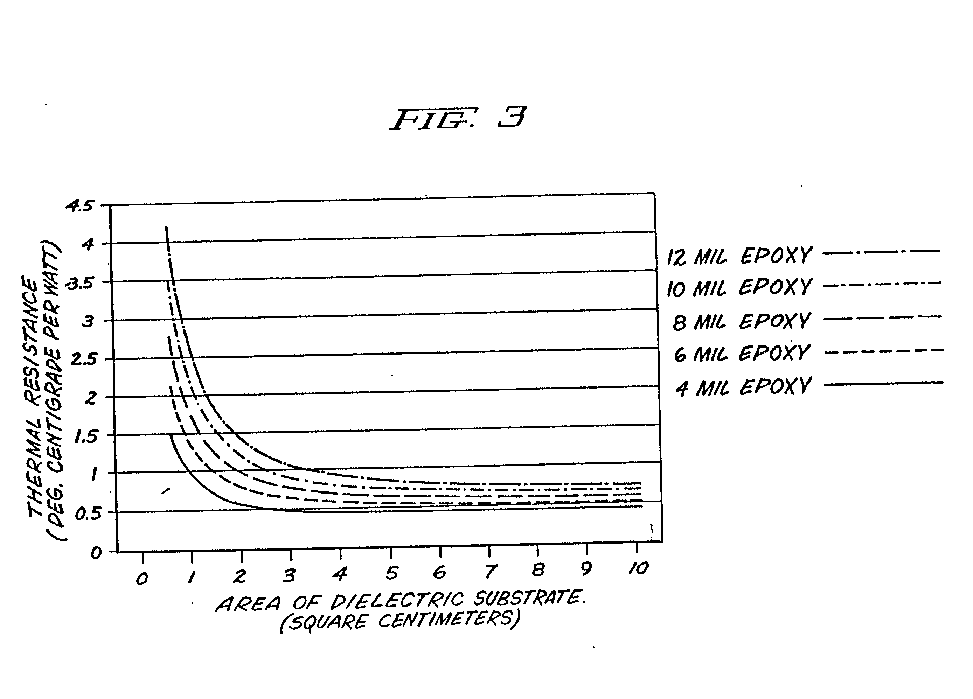

The structural adhesive 14 attaches or bonds the dielectric substrate 12 to the aluminum heat exchanger 13. The structural adhesive 14 is disposed between substantially the entire area of the lower surface of the dielectric substrate 12 and the upper or mounting surface of the aluminum heat exchanger 13. Suitable adhesives for implementing the structural adhesive 14 comprise a polymer-based adhesive such as epoxy, a thermoplastic adhesive, or an elastomeric adhesive, such as silicon rubber. Due the fact that the structural adhesive 14 is not required for dielectric isolation between the power device 11 and the aluminum heat exchanger 13, the typical (and poor) thermal conductivity thereof can be increased by the addition of a powdered material with high thermal conductivity such as powdered aluminum, copper silver, or beryllia. The thickness of the structural adhesive 14, between the dielectric substrate 12 and the aluminum heat exchanger 13, on one hand, should be large enough to accommodate roughness of, and deviations in the flatness of, the upper or mounting surface of the heat exchanger 13, and, on the other hand, should be small enough whereby the thermal resistance between the power device 11 and the aluminum heat exchanger 13 is not intolerably high. In Fig. 3, the values of thermal resistance between the active "junction" of a power device 11, where it comprises a power semiconductor device, and the aluminum heat exchanger 13 for different thicknesses of the structural adhesive 14 are plotted. The following fixed parameters apply to Fig. 3: the structural adhesive 14 comprises Thermal Bond X epoxy resin, referred to above; the power device 11 has a main or horizontal area of 0.63 square centimeters; and the dielectric substrate 12 comprises beryllia ceramic with a thickness of 40 mils. Fig. 3 additionally shows the variations of thermal resistance as the main or horizontal area of the dielectric substrate 12 is varied.

The structural adhesive 14, at least where it comprises epoxy, is considerably more resistant to temperature cycling fatigue than is the solder joint of the prior art power device module discussed above. The structural adhesive 14 advantageously is provided in a fillet configuration 14 around the peripheral edge of the dielectric substrate 12 in order to render the attachment or bond between the dielectric substrate 12 and the aluminum heat exchanger 13 more durable.

It will be appreciated from the foregoing that the inventive power device module 10 possesses numerous advantages over the prior art power device module discussed above. Due to the elimination of a metallic heat spreader plate, the problem of warpage thereof, as discussed above, is avoided. Additionally, the elimination of a metallic heat spreader plate greatly reduces the problems associated with non-flatness and roughness of the upper or mounting surface of the aluminum heat exchanger 13. The structural adhesive 14 is able to accommodate such non-flatness and roughness to a much greater extent than the prior art metallic heat spreader plate. Further, the inventive module 10 does not utilize a solder joint between a dielectric substrate and a metallic heat spreader plate. Therefore, the problems associated with voids in the solder, thermal cycling fatigue of the solder, and the need for providing solderable layers on the dielectric substrate and also on the metallic heat spreader plate, as discussed above, are avoided. Additionally, the elimination of such solder joint results in the power device 11 being subjected to less heat (from soldering) which would diminish the reliability thereof. Yet further, the inventive power device module 10 is able to be assembled with considerable ease relative to the assembly of the prior art module. This is especially due to the fact that the dielectric substrate 12 is easily bonded to the aluminum heat exchanger 13 with the structural adhesive 14. Still further, the inventive module 10 can be easily repaired due to the facility with which the bond provided by the structural adhesive 14 can be broken when desired. For example, where the structural adhesive 14 comprises epoxy, the bond provided thereby can be softened sufficiently for separation of the substrate 12 and the heat exchanger 13 simply by raising the temperature thereof to approximately 225°C.

While there has been shown and described specific embodiments of the present invention, it will be obvious to those skilled in the art that various changes and modifications may be made without departing from the invention in its broader aspects; and, therefore, it is intended that the appended claims cover all such changes and modifications as fall within the true spirit and scope of the invention.

CLAIMS

What is claimed as our invention and desired to be secured by Letters Patent of the United States is:

1. An improved power device module, comprising:

a) a power device;

b) a dielectric substrate having upper and lower surfaces, said power device being attached to said upper surface of said dielectric substrate, and the main area of said dielectric substrate being larger than the main area of said power device;

c) an aluminum heat exchanger having an upper surface; and

d) a structural adhesive disposed between substantially the entire area of said lower surface of said dielectric substrate and said upper surface of said aluminum heat exchanger.

2. The power device module of claim 1 wherein said dielectric substrate comprises beryllia ceramic.

3. The power device module of claim 2 wherein said beryllia ceramic has a thermal conductivity of about 2.2 watts per centimeter per degree Celsius.

4. The power device module of claim 1 wherein said dielectric substrate is selected from the group consisting of beryllia ceramic and alumina ceramic.

5. The power device module of claim 4 wherein said dielectric substrate has a main area greater than about 3 square centimeters.

6. The power device module of claim 4 wherein said dielectric substrate has a main area in excess of about 5 times the main area of said power device.

7. The power device module of claim 1 wherein said structural adhesive comprises a polymer based-adhesive.

8. The power device module of claim 7 wherein said structural adhesive comprises epoxy.

9. The power device module of claim 1 wherein said structural adhesive comprises a thermally conductive filler

10. The power device module of claim 9 wherein said conductive filler is selected from the group consisting of powdered aluminum, powdered copper, powdered silver and powdered beryllia.

11. The power device module of claim 1 wherein said structural adhesive is selected from the group consisting of a polymer, a thermoplastic adhesive, and an elastomeric adhesive.

12. The power device module of claim 4 wherein said dielectric substrate has a thickness between about 20 and 100 mils.

13. The power device module of claim 1 wherein said dielectric substrate has a thermal expansion coefficient in the normal temperature range of operation of said power device module which coefficient is between the thermal expansion coefficients of said power device and said aluminum heat exchanger.

14. The power device module of claim 1 wherein said aluminum heat exchanger comprises extruded aluminum.

15. The power device module of claim 1 further comprising structural adhesive configured into a fillet around at least part of the peripheral edge of said ceramic substrate.

10112-RD-13205

FIG. 1

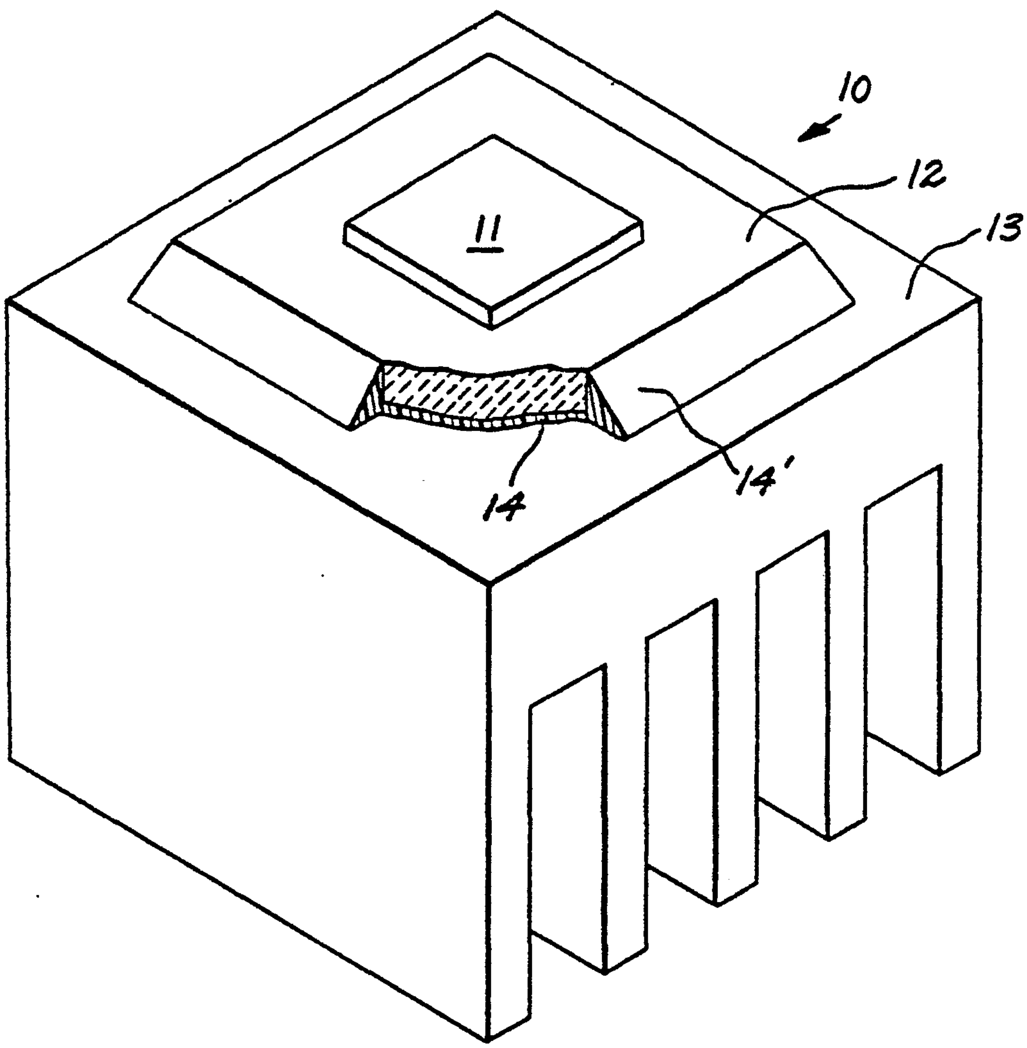

10112-RD-13205

FIG. 2

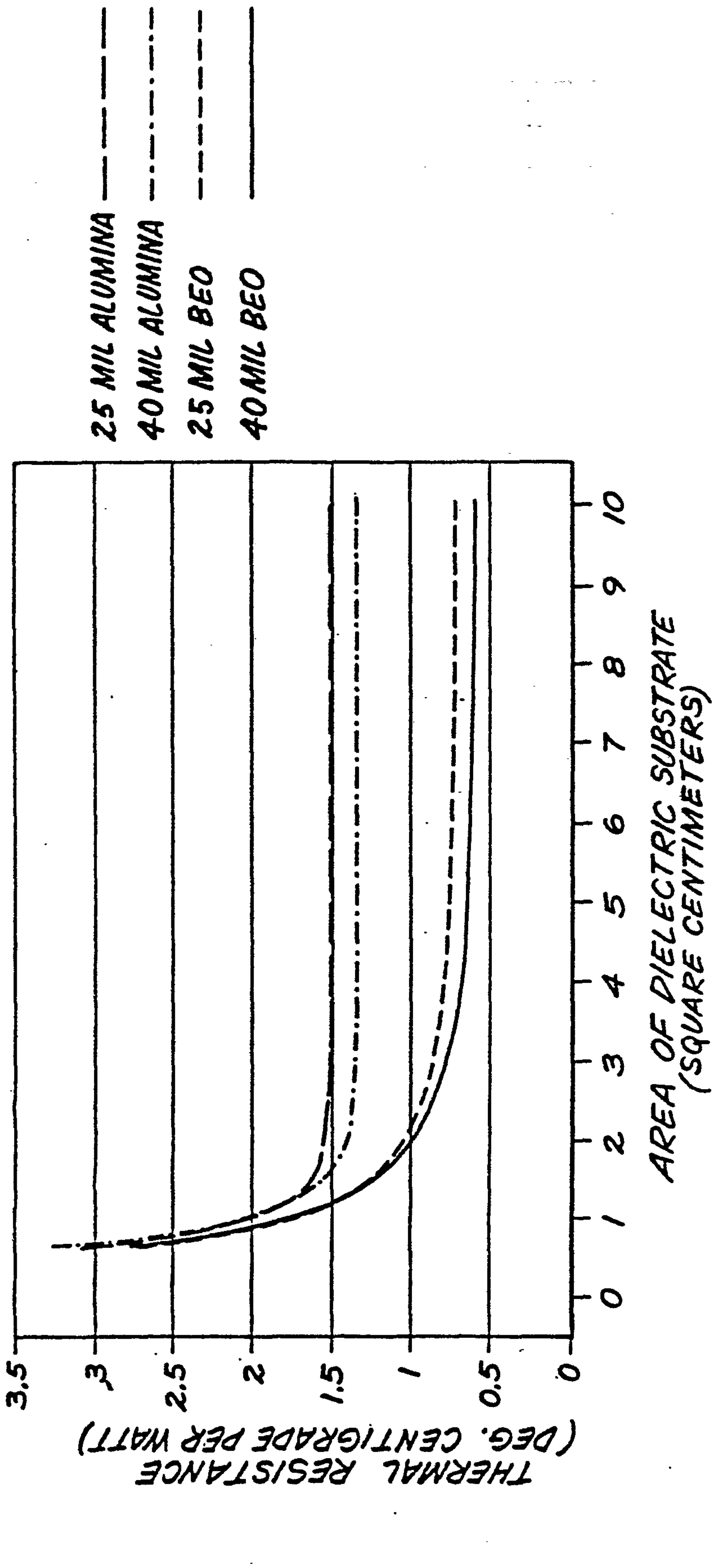

10112-RD-13205

FIG. 3